(19)

Europäisches Patentamt
European Patent Office
Office européen des brevets

(11) **EP 3 783 374 A1**

(12) **EUROPEAN PATENT APPLICATION**
published in accordance with Art. 153(4) EPC

(43) Date of publication:
**24.02.2021 Bulletin 2021/08**

(21) Application number: **20802369.7**

(22) Date of filing: **26.04.2020**

(51) Int Cl.:
***G01R 31/12*** (2020.01)

(86) International application number:
**PCT/CN2020/086925**

(87) International publication number:
**WO 2020/224458 (12.11.2020 Gazette 2020/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.05.2019 CN 201910376702**

(71) Applicants:
- **Electric Power Research Institute of State
  Grid Shandong Electric Power Company
  Shandong 250002 (CN)**
- **Beijing Rayiee Zhituo Technology
  Development Co., Ltd
  Beijing 100009 (CN)**
- **North China Electric Power University (Baoding)
  Baoding, Hebei 071003 (CN)**

(72) Inventors:
- **CHEN, Yufeng
  Jinan, Shandong 250002 (CN)**
- **WU, Tian
  Beijing 100055 (CN)**
- **LIU, Yunpeng
  Baoding, Hebei 071003 (CN)**
- **LIN, Ying
  Jinan, Shandong 250002 (CN)**

- **ZHOU, Jiabin
  Jinan, Shandong 250002 (CN)**
- **ZHANG, Zhenjun
  Jinan, Shandong 250002 (CN)**
- **SUN, Yuntao
  Jinan, Shandong 250002 (CN)**
- **QIN, Jiafeng
  Jinan, Shandong 250002 (CN)**
- **GAO, Pengfei
  Beijing 100055 (CN)**
- **LIU, Haipeng
  Beijing 100055 (CN)**
- **PU, Tingyan
  Beijing 100055 (CN)**
- **WU, Dan
  Beijing 100055 (CN)**
- **CHEN, Min
  Beijing 100055 (CN)**
- **PEI, Shaotong
  Baoding, Hebei 071003 (CN)**
- **LI, Yonglin
  Baoding, Hebei 071003 (CN)**
- **JI, Xinxin
  Baoding, Hebei 071003 (CN)**

(74) Representative: **Cabinet Beaumont
4, Place Robert Schuman
B.P. 1529
38025 Grenoble Cedex 1 (FR)**

(54) **METHOD FOR DETECTING CORONA DISCHARGE EMPLOYING IMAGE PROCESSING**

(57) Provided is an image processing-based corona detection method, including: intercepting each frame of image in an ultraviolet video outputted by a solar-blind ultraviolet imager; performing binarization processing on the intercepted image; performing an opening operation and closing operation of mathematical morphology on the image subjected to the binarization processing; eliminating a noise region in the image subjected to the opening operation and the closing operation by using a small-region area elimination algorithm; extracting an image quantization parameter from the image subjected to the noise elimination; and calculating an electrical signal quantization parameter of a corona according to the image quantization parameter and a pre-established photo-electric signal relationship model.

EP 3 783 374 A1

**(Cont. next page)**

Intercept each frame of image in an ultraviolet video outputted by a solar-blind ultraviolet imager — S10

Perform binarization processing on the intercepted image — S20

Perform an opening operation and closing operation of mathematical morphology on the image subjected to the binarization processing — S30

Eliminate, by utilizing a small-region area elimination algorithm on the image subjected to the opening operation and closing operation, a noise region in the image subjected to the opening operation and the closing operation — S40

Extract an image quantization parameter from the image subjected to the noise elimination — S50

Calculate an electrical signal quantization parameter of a corona according to the image quantization parameter and a pre-established photo-electric signal relationship model — S60

**FIG. 1**

## Description

This application claims priority to Chinese Patent Application No. 201910376702.2 filed on May 7, 2019, the disclosure of which is incorporated herein by reference in its entirety.

TECHNICAL FIELD

The present application relates to the technical field of corona detection, for example, to an image processing-based corona detection method.

BACKGROUND

High-voltage electrical equipment operating on site may experience insulation aging, deterioration, damage, cracking, loosening and other accidents under the long-term action of electric field, mechanical stress, and environmental factors. At the same time, if any link in design, manufacturing, installation, operation and maintenance of the electrical equipment is treated improperly, equipment defects can be caused, and consequent local electric field concentration may lead to corona discharge. The above-mentioned defects will pose a great threat to safe operation of power transmission and transformation equipment. Due to the characteristics of ultraviolet signal radiation in discharge, ultraviolet imagers begin to be used in the discharge detection of electrical equipment in a power system.

Since the application of an ultraviolet imaging technology in the power system is started in recent years, the relevant researches are mainly an application research, a qualitative research and a model research, mainly used to determine whether discharge exists and locate the discharge position. However, it is unable to determine the relationship between a detection result and traditional electrical pulse signals and unable to perform a quantitative analysis on discharge.

SUMMARY

An image processing-based corona detection method is provided by the present application to solve the problem that an ultraviolet imaging technology cannot determine a relationship between a detection result and traditional electrical pulse signals and cannot perform a quantitative analysis on discharge.

An image processing-based corona detection method provided by the present application includes steps described below.

Each frame of image in an ultraviolet video outputted by a solar-blind ultraviolet imager is intercepted.

Binarization processing is performed on the intercepted image.

An opening operation and closing operation of mathematical morphology are performed on the image subjected to the binarization processing.

A noise region in the image subjected to the opening operation and the closing operation is eliminated by using a small-region area elimination algorithm.

An image quantization parameter is extracted from the image subjected to the noise elimination. An electrical signal quantization parameter of a corona is calculated according to the image quantization parameter and a pre-established photo-electric signal relationship model.

BRIEF DESCRIPTION OF DRAWINGS

FIG. 1 is a flowchart of an image processing-based corona detection method according to an embodiment of the present application;
FIG. 2 is an image subjected to gray-scale processing according to an embodiment of the present application;
FIG. 3 is an image subjected to binarization processing according to an embodiment of the present application;
FIG. 4 is an image subjected to an opening operation and closing operation according to an embodiment of the present application;
FIG. 5 is an image subjected to a small-region area elimination algorithm according to an embodiment of the present application;
FIG. 6 is a schematic diagram of eight directions corresponding to a Freeman chain code according to an embodiment of the present application;
FIG. 7 is a schematic diagram of a correspondence between photoelectric parameters according to an embodiment of the present application; and

FIG. 8 is a schematic diagram of an imaging principle of a solar-blind ultraviolet imager according to an embodiment of the present application.

## DETAILED DESCRIPTION

Implementations of the present application are described below through specific embodiments. The present application may also be implemented or applied through other different implementations.

The drawings provided by the embodiments below merely illustrate the basic concept of the present application in a schematic manner. The drawings merely show the components related to the present application, rather than the numbers, shapes and sizes of components in the actual implementation. In the actual implementation, the type, number and proportion of each component may be changed arbitrarily, and the layout of the components may be more complicated.

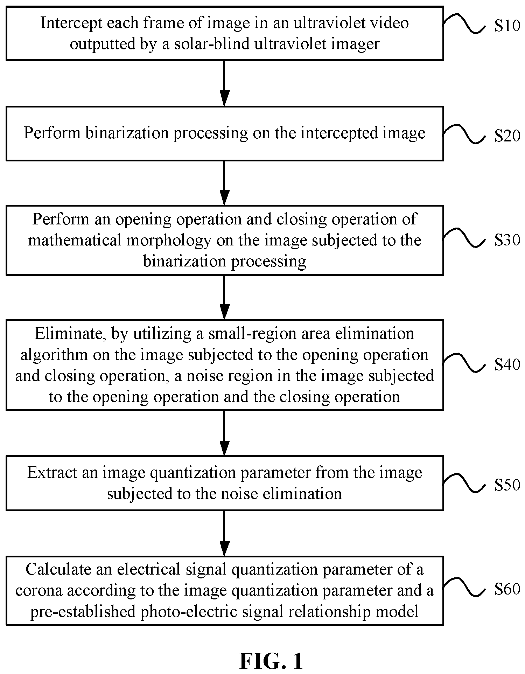

An image processing-based corona detection method provided by an embodiment of the present application as shown in FIG. 1 includes steps S10 to S60.

In S10, each frame of image in an ultraviolet video outputted by a solar-blind ultraviolet imager is intercepted.

In S20, binarization processing is performed on the intercepted image.

In S30, an opening operation and closing operation of mathematical morphology are performed on the image subjected to the binarization processing.

In S40, a noise region in the image subjected to the opening operation and closing operation is eliminated by using a small-region area elimination algorithm.

In S50, an image quantization parameter is extracted from the image subjected to the noise elimination.

In S60, an electrical signal quantization parameter of a corona is calculated according to the image quantization parameter and a pre-established photo-electric signal relationship model.

The solar-blind ultraviolet imager used in the embodiment of the present application is a CoroCAM 504 ultraviolet imager from South Africa. Firstly, each frame of image is intercepted from an ultraviolet video by using computer image processing software, then binarization processing is performed on an original ultraviolet image to obtain a binary image, then an opening operation and closing operation of mathematical morphology are performed on the binary image, and a small-region area elimination algorithm is applied to the image subjected to the opening operation and closing operation, so that a noise region in the image that is difficult to be filtered out by morphology can be removed.

The original image outputted by the ultraviolet imager is a red-green-blue (RGB) color digital image, each pixel in the image is represented by three color components of red, green and blue, and is stored in a form of M×N×3 in a computer. M and N are the number of rows and the number of columns of an image matrix respectively, and 3 represents the three color components of red, green and blue, that is, one image needs to be stored in three matrices. Therefore, the image may occupy a large image storage space, and the computational cost is relatively high if the original image is directly processed. Since the image of the discharge region is displayed to be white, the color of the image does not affect the subsequent extraction of a parameter. In order to facilitate subsequent processing, in the embodiment of the present application, the original image is converted into a gray-scale image before image segmentation is performed. The formula of gray-scale conversion is as follows:

$$Y=0.299R+0.587G+0.114B \hspace{3cm} (1).$$

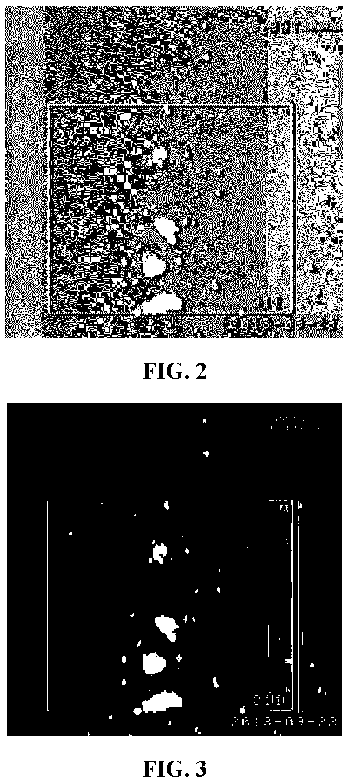

The physical meaning of Y is the grayscale of an image pixel point, R, G and B are three color component values of red, green and blue, Y is ranged from 0 to 255, the grayscale of a pure white pixel point is "255", and the grayscale of a pure black pixel point is "0". FIG. 2 is a gray-scale processed image according to an embodiment of the present application.

In order to extract an image quantization parameter, the image of each discharge region needs to be segmented from the ultraviolet image, and main algorithms for segmenting the image include: an edge detection method, a region growing method and a threshold method. However, the edge extracted by the edge detection method is often discontinuous, not convenient for the subsequent extraction of parameters; and for the region growing method, the center of the region needs to be determined artificially, the automation degree of extraction is low, and some discharge edges on site are discontinuous, so that the generated region boundary cannot reflect the real size of the discharge region. Since the grayscale of the discharge region is significantly higher than the grayscale of a background image, the embodiment of the present application adopts a threshold segmentation algorithm (i.e., binarization processing).

The principle of the threshold method is that each pixel of the gray-scale image is assigned with white (Y=255) or black (Y=0) within a specific value range, and the mathematical model of the threshold method is as follows:

$$g(x,y) = \begin{cases} 255, & f(x,y) \geq t \\ 0, & f(x,y) < t \end{cases} \qquad (2).$$

In the formula (2), *t* denotes a threshold value, *g(x, y)* denotes a binarized grayscale, *f(x, y)* denotes a grayscale before binarization and *(x, y)* denotes a pixel coordinate.

Due to the fact that the discharge region in the ultraviolet image is displayed as white color, and the grayscale of the background image is generally far lower than the grayscale of the discharge region, it is found from a large number of histograms of the tested gray-scale image that an apparent valley exits when the grayscale is around 220, so 220 is selected as a default threshold first, and if the processing effect is not good, the threshold may be changed to perform threshold segmentation on the image again until a good effect is achieved. FIG. 3 is an image subjected to binarization processing according to an embodiment of the present application.

Although a certain denoising effect can be achieved after the binarization processing is performed on the image, for some pixel points whose grayscales are close to the grayscales of the discharge region, the noise still cannot be removed after binarization. In order to extract the discharge region more accurately, filtering processing is performed on the binary image by adopting an opening and closing operation of mathematical morphology in the present application.

Basic morphological operations include an erosion operation and a dilation operation. The erosion operation and the dilation operation refer to that an original image A is convoluted with a kernel (structuring element) B. The erosion operation is to calculate a minimum pixel value in a region covered by the structuring element B and assign the minimum pixel value to a pixel point designated by a reference point in the structuring element B; and the dilation operation is to calculate a maximum pixel value in the region covered by the structuring element B and also to assign the maximum pixel value to a pixel point designated by the reference point in the structuring element B. Using a set and vector displacement operation to represent the erosion operation and the dilation operation is as follows:

$$A\ominus B(x,y) = \left\{ (x,y) \middle| \min_{n_1,n_2 \in kernel} A(x+n_1, y+n_2) \right\} \qquad (3)$$

$$A\oplus B(x,y) = \left\{ (x,y) \middle| \min_{n_1,n_2 \in kernel} A(x+n_1, y+n_2) \right\} \qquad (4).$$

The formula (3) indicates calculating the minimum pixel point in the region where A is covered by the structuring element B, and the set formed by such pixel points is the pixel points subjected to the erosion operation. The formula (4) indicates calculating the maximum pixel point in the region where A is covered by the structuring element B, and the set formed by such pixel points is the pixel points subjected to the dilation operation. $n_1$ and $n_2$ are integers related to the size of B. Therefore, it can be seen from the above formulas (3) and (4) that the subsequent parameter calculation will be affected if only the erosion operation or the dilation operation is performed on the image. However, the two operations are not inverse operations, so the two operations may be used in cascade, an operation that the erosion operation is performed before the dilation operation is the opening operation, and an operation that the dilation operation is performed before the erosion operation is the closing operation. The opening operation and the closing operation are defined as follows:

$$A \circ B = (A\ominus B)\oplus B \qquad (5)$$

$$A \bullet B = (A\oplus B)\ominus B \qquad (6).$$

The opening operation can eliminate isolated points higher than adjacent points, eliminate tiny points between object boundaries without significantly changing the area, and meanwhile achieve a smoothing effect. The closing operation can eliminate isolated points lower than adjacent points, and fill and smooth the boundaries of adjacent objects without significantly changing the area. Considering that the discharge region is generally circular, the selected structuring element is of a circular structure.

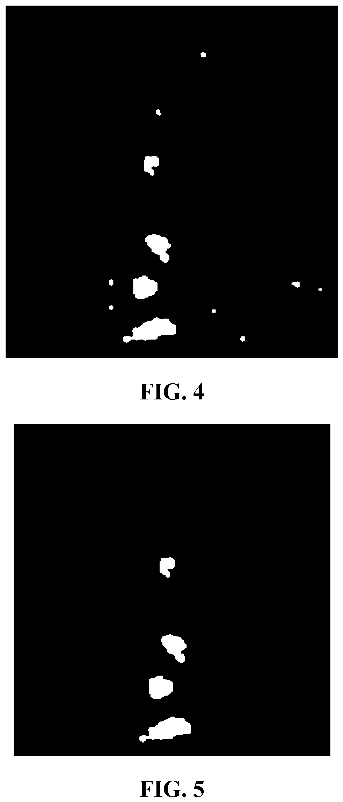

The radius of the structuring element needs to be determined according to image characteristics. If the structuring element is too small, the effective filtering effect may not be achieved; and if the structuring element is too large, the image will be distorted greatly. Since the diameter of the image of the noise region in the ultraviolet image is generally fewer than 10 pixel points, the radius of the structuring element in the embodiment of the present application is selected to be ranged from 2 to 5. During filtering, the initial radius is 2. If the filtering effect is not good, the radius is increased by 1, and the image is filtered again. If the filtering effect is still not ideal, the radius is continuously increased for filtering. The radius will not be continuously increased if the radius reaches the maximum of 5 and part of noise still cannot be filtered out, which means some large noise interference points exist in the image, and the small-region area elimination algorithm may be adopted subsequently for filtering. FIG. 4 is an image subjected to an opening operation and closing operation according to an embodiment of the present application.

After mathematical morphology filtering processing, a large number of interference points still exit as shown in FIG. 4, but the area of interference points is much smaller than the area of electric light spots, so the small-region area elimination algorithm for the binary image is adopted in the present application to remove the interference points shown in FIG. 4. The basic steps of the algorithm are described below.

a) Each highlight region shown in FIG. 4 is detected, and boundary information of each region is acquired.

b) The size of the area of each connected region is acquired through the boundary information. Through statistics, 12 connected regions exist in the FIG. 4, and the number of pixels included in each connected region are shown in Table 1.

Table 1 The number of pixels included in each region

| Serial number of an area | $S_1$ | $S_2$ | $S_3$ | $S_4$ | $S_5$ | $S_6$ | $S_7$ | $S_9$ | $S_9$ | $S_{10}$ | $S_{11}$ | $S_{12}$ |
|---|---|---|---|---|---|---|---|---|---|---|---|---|
| Number of pixels in each region | 1249. 5 | 738 | 717 | 350.5 | 58 | 36 | 35 | 29. 5 | 27 | 26 | 16 | 12 |

c) A threshold value is set to be 100, the area of each region is sequentially compared with the threshold value, the region whose area is larger than the threshold value is reversed, and the region whose area is smaller than the threshold value will be eliminated to obtain the image as shown in FIG. 5. After filtering is performed, the number of discharge regions obtained is four. From FIG. 5 it can be known that the above algorithm effectively filters out noise regions and preserves the discharge regions, and at the same time the filtering method has no impact on the sizes and shapes of the images of the discharge regions themselves.

After the small-region area elimination is performed, the image quantization parameter is extracted. The image quantization parameter includes the number of photons, a light spot area, a region boundary perimeter, a major axis, and a minor axis.

The number of photons is obtained through the direct output of the ultraviolet imager.

The light spot area refers to the number of pixel points included in the discharge light spot region.

The region boundary perimeter is similar to the concept of continuous curve length in geometry, and the value of the region boundary perimeter is the sum of the numbers of consecutive pixel points on boundary points.

As for major and minor axes, since the discharge on the surface of external insulation equipment sometimes appears to be slender and the discharge characteristics cannot be well reflected by only using area and perimeter parameters, two parameters of the major axis and the minor axis are introduced. The major axis is defined as the longest distance passing through a centroid point of and between two points on an edge of the discharge region. The minor axis is defined as the shortest distance passing through the centroid point of and between two points on an edge of the discharge region.

To obtain the quantization parameters of the image of the discharge region, contour boundary points of each discharge region need to be extracted, and since more than one discharge points often exist in the ultraviolet image, extraction of coordinates of multi-region boundary contour points is a core link in the algorithm. The embodiment of the present application adopts a multi-region boundary tracking algorithm, and the basic principle and the steps are described below.

a) Each highlight region shown in the FIG. 5 is detected, and the boundary information of each region is acquired.

b) The size of the area of each connected region is acquired through the boundary information.

c) A threshold value is set, the area of each region is sequentially compared with the threshold value, the region whose area is larger than the threshold value is reversed, and the region whose area is smaller than the threshold value will be eliminated.

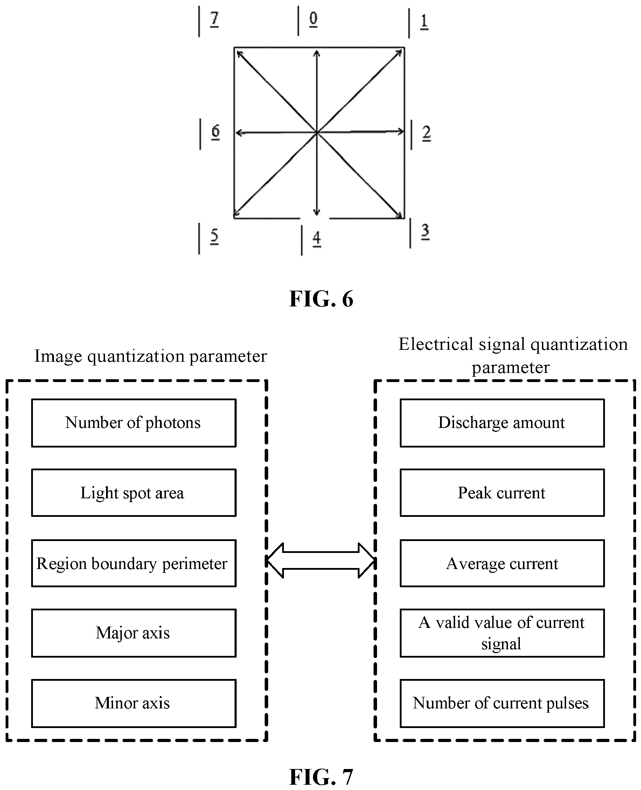

An approximate method of retrieving the boundary is adopted to access the contour by using a Freeman chain code. The Freeman chain code generally performs a contour detection in eight directions, namely 0, 1, 2, 3, 4, 5, 6 and 7, and a schematic diagram of eight directions provided by the embodiment of the present application is shown in FIG. 6.

Pixel values in eight directions are detected in a counterclockwise or clockwise direction with an initial point as a center, and the whole picture is detected from top to bottom and from left to right. When a boundary point is detected, the boundary point is defined as an edge detection starting point and is stored in the chain code, the detection is continued downward until returning to the edge detection starting point, and the detection of one contour is completed; and codes representing the eight directions of the contour are stored in the chain code.

Therefore, coordinate values of a plurality of pixel points on the boundary of each region can be obtained. To visually display whether the extracted boundary satisfies requirements, the coordinates of the extracted boundary points are sequentially connected to form a closed curve, the closed curve is superposed on the original image, and the label of each region is displayed at the center point of each region, so that the extraction effect of the extracted discharge region can be conveniently evaluated. If the closed curve is in good coincidence with the boundary of the original image, the extraction effect is good, and if the closed curve is not in coincidence with the boundary of the original image, the extraction needs to be performed again.

After a multi-region contour tracking algorithm is adopted, coordinate values of boundary points of four discharge regions in FIG. 5 can be obtained. A plurality of coordinate values are connected to form a closed curve to be superposed on the original image, the boundary of the image almost coincides with the original image, that is, the discharge light spots can be effectively segmented while interference points are filtered out by the above image processing algorithm, and the distortion effect on the light spot region is small.

After the contour is extracted, a chain code table of each region is generated, a line segment table can be obtained by performing linear transformation on the chain code table, and coordinates of points on the boundary of the discharge region are stored in the line segment table. Therefore, parameters such as the area, the perimeter, an equivalent major axis, an equivalent minor axis and the like of the discharge region can be obtained through the chain code table and the line segment table.

(1) Light spot area s

The total number of pixel points in a designated region is calculated as the area of a region. If the pixel point with a grayscale of 255 in the discharge region in the binary image is defined as 1, the area is the total number of Is in the region. The formula is as follows:

$$S = \sum_{(x,y \in Q)} 1 \qquad (8).$$

(2) Region boundary perimeter

The calculation of the light spot perimeter is calculating the sum of continuous lengths of boundary points of the light spot, and the distance between adjacent bright points on the boundary is only 1 or $\sqrt{2}$. It can be seen from FIG. 6 that relative to the current boundary point, the chain code value of adjacent points with the distance of 1 is 0 or an even number, and the chain code value of adjacent points with the distance of $\sqrt{2}$ is an odd number. If the number of boundary points with the distance of 1 and the number of boundary points with the distance of $\sqrt{2}$ on the whole boundary of the designated region are counted, the perimeter calculation formula is as follows:

$$C(x,y) = P \times 1 + Q \times \sqrt{2}, \, x,y \in A \qquad (9).$$

P is the number of boundary points with the distance of 1 and Q is the number of boundary points with the distance of $\sqrt{2}$.

(3) Calculation of an equivalent diameter, the equivalent major axis and the equivalent minor axis

The discharge region is approximately circular, so when the diameter of the discharge light spot is calculated, the equivalent diameter is obtained by using an area calculation formula of a circle.

The calculation of the equivalent major axis is calculating the longest distance between two ends connected through the region center of the discharge region. The equivalent major axis is the shortest distance between two ends connected through the region center of the discharge region.

Based on the above parameter definition method, the quantization parameter table obtained by calculating the four discharge regions of the FIG. 5 is shown in Table 2.

Table 2 Extraction of an ultraviolet detection discharge quantization parameter

| Serial number of a discharge point | Area of a light spot | Perimeter of a light spot | Equivalent major axis of a light spot | Equivalent minor axis of a light spot |
|---|---|---|---|---|
| 1 | 350.5 | 87.3 | 27.65 | 13.58 |
| 2 | 717 | 122.33 | 43.57 | 22.85 |
| 3 | 738 | 105.25 | 34.4 | 26.92 |
| 4 | 1249.5 | 182.88 | 71.98 | 24.51 |

The electrical signal quantization parameters of a corona include a discharge amount, a peak current, a average current, a valid value of a current signal, and a number of current pulses. The photo-electric signal relationship model illustrates a mapping relationship between the electrical signal quantization parameter of a corona and the image quantization parameter.

The steps for establishing a mapping relationship between the electrical signal quantization parameter of a corona and the image quantization parameter include: pre-testing a plurality of sample data, and extracting electrical signal quantization parameters of the corona and image quantization parameters from the plurality of sample data; establishing a photoelectric relationship curve between photoelectric parameters according to the extracted electrical signal quantization parameters of the corona and the extracted image quantization parameters; and determining the mapping relationship between the electrical signal quantization parameter of the corona and the image quantization parameter according to the photoelectric relationship curve. Due to the randomness of discharge, a large amount of sample data is obtained through tests, the electrical signal quantization parameters and the image quantization parameters are extracted from the sample data, and an photoelectric relationship curve between the photoelectric parameters shown in FIG. 7 is sequentially established, so that an electrical signal quantization parameter that has a strong association relationship with an optical signal quantization parameter can be obtained.

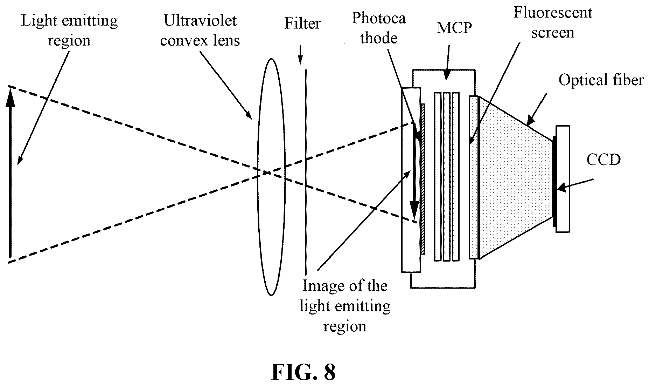

Discharge of external insulation equipment has strong randomness, and electrical signals collected by the data acquisition system have high temporal resolution. The ultraviolet imager is limited by the working principle. FIG. 8 shows an imaging principle of the solar-blind ultraviolet imager; firstly, an ultraviolet image is converted into an electronic image by using an ultraviolet photocathode, and then the electronic image is gain-amplified through a microchannel plate (MCP). An electron flow outputted by the MCP is bombarded at a high speed on a fluorescent screen at a rear part of the MCP, and thus the electronic image is converted into a visible light image and then is acquired and imaged through a charge coupled device (CCD), so the resolution to time is low, the relationship between the electrical signal quantization parameter and the optical signal quantization parameter is inevitably complex, and therefore the mapping relationship between the electrical signal quantization parameter and the image quantization parameter is a complex non-linear relationship. A quantitative association relationship between the image quantization parameter and the electrical signal quantization parameter is established through a regression analysis. In statistics, the regression analysis refers to a statistical analysis method for determining the quantitative relationship of interdependence between two or more variables. In a large data analysis, the regression analysis is a predictive modeling technique that studies the relationship between a dependent variable (target) and an independent variable (predictor). This technique is commonly used for predictive analyses, time series models, and discovery of causal relationships between variables. The regression analysis method used in the embodiment of the present application may be least squares regression, neural network regression, support vector machine regression and kernel regression, so that the photo-electric signal relationship model can be established by using the regression analysis. After the photo-electric signal relationship model is established, the photo-electric signal relationship model can be used in the corona detection. As long as the image quantization parameter is obtained after the image in the ultraviolet video outputted by the solar-blind ultraviolet imager is subjected to image processing and then the electrical signal quantization parameter (i.e., the discharge amount, the peak current, the average current, the valid value of a current signal , and the number of current pulses) is obtained according to the image quantization parameter and the photo-electric signal relationship model. In this way, the relationship between the detection result and the traditional electrical pulse signals is determined, and the quantitative analysis on discharge is performed.

**Claims**

1. An image processing-based corona detection method, comprising:

intercepting each frame of image in an ultraviolet video outputted by a solar-blind ultraviolet imager;
performing binarization processing on the intercepted image;
performing an opening operation and closing operation of mathematical morphology on the image subjected to the binarization processing;
eliminating a noise region in the image subjected to the opening operation and the closing operation by using a small-region area elimination algorithm;
extracting an image quantization parameter from the image subjected to the noise elimination; and
calculating an electrical signal quantization parameter of a corona according to the image quantization parameter and a pre-established photo-electric signal relationship model.

2. The method according to claim 1, wherein the image quantization parameter comprises a number of photons, a light spot area, a region boundary perimeter, a major axis, and a minor axis.

3. The method according to claim 2, wherein the light spot area represents a number of pixel points comprised in a discharge light spot region, the region boundary perimeter represents a sum of consecutive pixel points on boundary points in the discharge light spot region, the major axis represents a longest distance between two points on an edge of the discharge light spot region, and the minor axis represents a shortest distance between two points on the edge of the discharge light spot region.

4. The method according to any one of claims 1 to 3, wherein the electrical signal quantization parameter of the corona comprises a discharge amount, a peak current, an average current, a valid value of a current signal and a number of current pulses.

5. The method according to claim 4, wherein the photo-electric signal relationship model is a mapping relationship between the electrical signal quantization parameter of the corona and the image quantization parameter.

6. The method according to claim 5, further comprising:

pre-testing a plurality of sample data, and extracting electrical signal quantization parameters of the corona and image quantization parameters from the plurality of sample data;
establishing a photoelectric relationship curve between photoelectric parameters according to the extracted electrical signal quantization parameters of the corona and the extracted image quantization parameters; and
determining the mapping relationship between the electrical signal quantization parameter of the corona and the image quantization parameter according to the photoelectric relationship curve to obtain the photo-electric signal relationship model.

7. The method according to claim 6, wherein a method for determining the mapping relationship between the electrical signal quantization parameter of the corona and the image quantization parameter according to the photoelectric relationship curve comprises at least one of: least squares regression, neural network regression, support vector machine-regression or kernel regression.

| Intercept each frame of image in an ultraviolet video outputted by a solar-blind ultraviolet imager | S10 |

↓

| Perform binarization processing on the intercepted image | S20 |

↓

| Perform an opening operation and closing operation of mathematical morphology on the image subjected to the binarization processing | S30 |

↓

| Eliminate, by utilizing a small-region area elimination algorithm on the image subjected to the opening operation and closing operation, a noise region in the image subjected to the opening operation and the closing operation | S40 |

↓

| Extract an image quantization parameter from the image subjected to the noise elimination | S50 |

↓

| Calculate an electrical signal quantization parameter of a corona according to the image quantization parameter and a pre-established photo-electric signal relationship model | S60 |

**FIG. 1**

**FIG. 2**

**FIG. 3**

**FIG. 4**

**FIG. 5**

**FIG. 6**

Image quantization parameter

Electrical signal quantization parameter

| Number of photons |
| Light spot area |
| Region boundary perimeter |
| Major axis |
| Minor axis |

| Discharge amount |
| Peak current |
| Average current |
| A valid value of current signal |
| Number of current pulses |

**FIG. 7**

Light emitting          Ultraviolet     Filter    Photoca           Fluorescent
    region             convex lens               thode    MCP        screen

                                                                         Optical fiber

                                                                              CCD

                                                        Image of the
                                                        light emitting
                                                          region

**FIG. 8**

## INTERNATIONAL SEARCH REPORT

| International application No. |
| --- |
| **PCT/CN2020/086925** |

| **A. CLASSIFICATION OF SUBJECT MATTER** |
| --- |
| G01R 31/12(2006.01)i |
| According to International Patent Classification (IPC) or to both national classification and IPC |

| **B. FIELDS SEARCHED** |
| --- |
| Minimum documentation searched (classification system followed by classification symbols) |
| G01R; G06T |
| Documentation searched other than minimum documentation to the extent that such documents are included in the fields searched |
| |
| Electronic data base consulted during the international search (name of data base and, where practicable, search terms used) |
| CNABS; CNTXT; CNKI; VEN; USTXT; WOTXT; EPTXT; IEEE: 电晕, 放电, 紫外, 量化, 图像, 函数, 曲线, 拟合, 关系, corona, discharge, ultraviolet, UV, imag+, function, curve, fitting |

| **C. DOCUMENTS CONSIDERED TO BE RELEVANT** | | |
| --- | --- | --- |
| Category* | Citation of document, with indication, where appropriate, of the relevant passages | Relevant to claim No. |
| PX | CN 110146791 A (STATE GRID SHANDONG ELECTRIC POWER RESEARCH INSTITUTE et al.) 20 August 2019 (2019-08-20) claims 1-7 | 1-7 |
| X | CN 106054032 A (NORTH CHINA ELECTRIC POWER UNIVERSITY (BAODING)) 26 October 2016 (2016-10-26) description paragraphs [0002], [0007], [0061]-[0114] | 1, 4-7 |
| Y | CN 106054032 A (NORTH CHINA ELECTRIC POWER UNIVERSITY (BAODING)) 26 October 2016 (2016-10-26) description paragraphs [0002], [0007], [0061]-[0114] | 2-7, |
| Y | CN 103543394 A (NORTH CHINA ELECTRIC POWER UNIVERSITY (BAODING)) 29 January 2014 (2014-01-29) description, paragraphs [0003]-[0012] | 2-7, |
| Y | CN 103018640 A (NORTH CHINA ELECTRIC POWER UNIVERSITY (BAODING)) 03 April 2013 (2013-04-03) description, paragraphs [0015]-[0048] | 1-7 |

☑ Further documents are listed in the continuation of Box C.　　☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **12 June 2020** | **03 July 2020** |

| Name and mailing address of the ISA/CN | Authorized officer |
| --- | --- |
| **China National Intellectual Property Administration (ISA/ CN)** **No. 6, Xitucheng Road, Jimenqiao Haidian District, Beijing 100088 China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2020/086925** |

**C.     DOCUMENTS CONSIDERED TO BE RELEVANT**

| Category* | Citation of document, with indication, where appropriate, of the relevant passages | Relevant to claim No. |
| --- | --- | --- |
| Y | CN 105004972 A (NORTH CHINA ELECTRIC POWER UNIVERSITY (BAODING)) 28 October 2015 (2015-10-28) description, paragraphs [0007]-[0044] | 1-7 |
| A | CN 204479836 U (OFIL, LTD.) 15 July 2015 (2015-07-15) entire document | 1-7 |

Form PCT/ISA/210 (second sheet) (January 2015)

**INTERNATIONAL SEARCH REPORT**
Information on patent family members

International application No.

**PCT/CN2020/086925**

| Patent document cited in search report | | | Publication date (day/month/year) | Patent family member(s) | | | Publication date (day/month/year) |
|---|---|---|---|---|---|---|---|
| CN | 110146791 | A | 20 August 2019 | None | | | |
| CN | 106054032 | A | 26 October 2016 | CN | 106054032 | B | 03 March 2020 |
| CN | 103543394 | A | 29 January 2014 | CN | 103543394 | B | 03 February 2016 |
| CN | 103018640 | A | 03 April 2013 | None | | | |
| CN | 105004972 | A | 28 October 2015 | CN | 105004972 | B | 28 November 2017 |
| CN | 204479836 | U | 15 July 2015 | WO | 2015104593 | A1 | 16 July 2015 |
| | | | | GB | 2522095 | A | 15 July 2015 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910376702